(19) Europäisches Patentamt
European Patent Office
Office européen des brevets

(11) **EP 3 546 365 A1**

(12) **DEMANDE DE BREVET EUROPEEN**

(43) Date de publication:
**02.10.2019 Bulletin 2019/40**

(51) Int Cl.:
***B64D 15/20*** *(2006.01)*

(21) Numéro de dépôt: **19159019.9**

(22) Date de dépôt: **25.02.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **30.03.2018 FR 1852810**

(71) Demandeur: **Airbus Operations S.A.S.**
**31060 Toulouse (FR)**

(72) Inventeurs:
• **CALMELS, Alice**
**31700 BLAGNAC (FR)**
• **CLAVEL, Thierry**
**82000 MONTAUBAN (FR)**

(74) Mandataire: **Gicquel, Olivier Yves Gérard**
**Airbus Opérations (S.A.S)**
**XIF - M0101/1**
**316, route de Bayonne**
**31060 Toulouse Cedex (FR)**

(54) **DÉTECTION DE CONDITIONS GIVRANTES POUR UN AÉRONEF PAR ANALYSE DE CONSOMMATION DE COURANT ÉLECTRIQUE**

(57)    La présente invention concerne un procédé et un système de détection de conditions de givrage pour un aéronef, ledit aéronef comprenant des sondes (5) installées sur sa peau ainsi qu'un calculateur (7) configuré pour acquérir des mesures d'intensités électriques parcourant les sondes afin de gérer leur consommation électrique, ledit calculateur (7) étant en outre configuré pour comparer les intensités électriques parcourant au moins deux sondes (5) et pour déduire des conditions de givrage à partir de ladite comparaison.

FIG.1

EP 3 546 365 A1

**Description**

**DOMAINE TECHNIQUE**

La présente invention concerne de manière générale l'estimation des conditions météorologiques dans lesquelles se trouve un aéronef et plus particulièrement, la détection des conditions givrantes.

**ÉTAT DE LA TECHNIQUE ANTÉRIEURE**

La survenance de conditions givrantes en vol peut affecter les performances des aéronefs. Ainsi, lorsque les aéronefs sont habilités à voler dans des conditions givrantes, ils sont équipés de systèmes de protection, intégrés aux éléments à protéger (voilure, entrées d'air moteur, sondes Pitot etc.). Les systèmes de protection se présentent notamment sous la forme de systèmes chauffants prévenant la formation ou l'accumulation du givre.

L'activation d'au moins une partie de ces systèmes de protection repose généralement sur le jugement du pilote après qu'il ait identifié la présence de conditions givrantes. Il est généralement fait recours à des systèmes de détection mécanique et/ou optique pour aider le pilote dans son jugement. On notera que certains éléments comme les capteurs types sondes Pitot sont protégés en continu par des systèmes chauffants et par conséquent, aucune action pilote n'est requise pour les protéger des conditions givrantes. En revanche, d'autres éléments comme les voilures et entrées d'air moteurs requièrent pour leur protection une action pilote ponctuelle suite à une détection de conditions givrantes par le système de détection.

Ainsi, il est courant d'équiper un aéronef de capteurs dédiés à la détection de conditions givrantes montés sur la peau de l'aéronef et d'exploiter les mesures obtenues pour diagnostiquer la présence de givre. Une appréciation des mesures par le pilote reste nécessaire prenant en compte la phase de vol, la criticité des fonctions remplies par les éléments affectés par le givre et des marges de sécurité associées, afin d'éviter tout déclenchement intempestif des systèmes de protection.

Ces capteurs spécifiques de détection sont installés sur la peau du fuselage ou une surface de l'aéronef, ce qui, d'une part, nécessite de percer le fuselage ou la surface en question, de prévoir des renforts mécaniques à proximité du trou, de déployer un câblage électrique et d'installer des systèmes d'acquisition supplémentaires dans des armoires électriques multipliant les poids et coûts. En outre, les capteurs spécifiques dépassent souvent de la peau du fuselage et engendrent par conséquent une trainée qui peut affecter les performances de l'aéronef.

Les capteurs spécifiques actuels de détection remplissent bien leur fonction d'une détection globale des conditions givrantes, mais ne sont pas adaptés pour fournir un diagnostic plus précis. En effet, ces capteurs spécifiques ne sont pas adaptés pour discerner la formation de larges gouttes d'eau ou de cristaux de glace.

Un objet de la présente invention est de proposer un système de détection de conditions givrantes pour un aéronef, qui remédie au moins en partie aux inconvénients ci-dessus, en particulier qui ne requiert pas d'opérations de perçage et de câblage supplémentaires, n'augmente ni le poids de l'avion ni sa trainée aérodynamique, et permette à la fois d'appréhender une large gamme de conditions givrantes et de fournir un diagnostic plus précis que dans l'art antérieur.

**EXPOSÉ DE L'INVENTION**

La présente invention concerne un système de détection de conditions de givrage pour un aéronef, ledit aéronef comprenant des sondes installées sur sa peau ainsi qu'un calculateur configuré pour acquérir des mesures d'intensités électriques parcourant les sondes afin de gérer leur consommation électrique, le calculateur étant en outre configuré pour comparer les intensités électriques parcourant au moins deux sondes et pour déduire des conditions de givrage à partir de ladite comparaison.

Ainsi, la comparaison des intensités de courant électriques déjà disponibles des sondes permet de détecter la présence de nuages, les conditions givrantes et la concentration d'eau des nuages. Il n'est plus nécessaire d'installer des détecteurs spécifiques de givre permettant ainsi de réduire le poids, les coûts, les maintenances et la consommation électrique.

Avantageusement, le calculateur est configuré pour calculer le ratio de courants entre des première et deuxième intensités de courant parcourant respectivement des première et deuxième sondes installées sur différents emplacements de l'aéronef, ledit ratio étant indicatif des conditions de givrage.

Ainsi, un simple calcul de ratio de courants déjà mesurés permet d'avoir de manière surprenante une indication très fiable des conditions de givrage.

Avantageusement, le calculateur est configuré pour déterminer un paramètre indicatif des conditions givrantes en divisant ledit ratio de courants par le rapport entre des premier et deuxième coefficients de captation d'eau relatifs respectivement auxdites première et deuxième sondes ainsi que par une constante hors nuage.

Le paramètre de conditions givrantes permet d'indiquer la présence et le type de conditions givrantes en discriminant entre des particules liquides ou solides.

Avantageusement, les coefficients de captation d'eau sont prédéterminés par un code aérodynamique en fonction des conditions de vol, de l'emplacement des sondes et des conditions atmosphériques, les valeurs desdits coefficients de captation étant consignées dans des abaques qui sont stockés dans une unité de stockage.

Avantageusement, la constante hors nuage est prédéterminée par une mesure du ratio de courants relatif auxdites première et deuxième sondes dans des conditions atmosphériques d'air sec.

Selon un mode de réalisation de la présente invention, le calculateur est en outre configuré pour déduire les conditions de givrage en utilisant des données d'apprentissage préalablement enregistrées. Ceci permet d'élargir le spectre de détection et d'affiner l'interprétation des conditions de givrage.

Avantageusement, le calculateur est configuré pour surveiller au cours du temps l'évolution du paramètre indicatif des conditions givrantes lors des différents vols de l'aéronef. Ceci permet de surveiller l'évolution des conditions de givrage et de la concentration en eau des nuages.

Avantageusement, les données des conditions givrantes sont indiquées en temps réel sur une interface au cockpit de l'aéronef.

Ces données permettent ainsi d'aider le pilote dans son jugement concernant l'activation des systèmes de protection.

Avantageusement, le calculateur est configuré pour comparer deux-à-deux les intensités électriques parcourant une pluralité de sondes installées en différents endroits de l'aéronef.

Ceci permet de sonder la concentration en eau des nuages.

Avantageusement, les données des conditions givrantes déterminées par le calculateur sont transmises par l'aéronef à une station météorologique au sol.

Ainsi, la station au sol peut collecter des données météorologiques de plusieurs sources en altitude.

L'invention vise également un aéronef comportant le système de détection de conditions de givrage selon l'une quelconque des caractéristiques précédentes.

L'invention vise aussi un procédé de détection de conditions de givrage pour un aéronef, ledit aéronef comprenant des sondes installées sur sa peau ainsi qu'un calculateur configuré pour acquérir des mesures d'intensités électriques parcourant les sondes afin de gérer leur consommation électrique, ledit procédé comportant une comparaison des intensités électriques parcourant au moins deux sondes et une déduction des conditions de givrage à partir de ladite comparaison.

**BRÈVE DESCRIPTION DES DESSINS**

D'autres caractéristiques et avantages de l'invention apparaîtront à la lecture d'un mode de réalisation préférentiel de l'invention, fait en référence aux figures jointes parmi lesquelles :

La Fig. 1 représente de manière schématique un aéronef comportant un système de détection de conditions givrantes, selon un mode de réalisation de l'invention;
La Fig. 2 illustre de manière schématique un système de détection de conditions givrantes, selon un mode de réalisation préféré de l'invention ;
La Fig. 3 illustre des courbes de coefficients de captation d'eau en fonction de la distance de la peau de l'aéronef et selon différentes conditions de vol de l'aéronef, selon l'invention ;
La Fig. 4 est un graphique illustrant le paramètre indicatif des conditions givrantes, selon un mode de réalisation de l'invention ; et
La Fig. 5 représente de manière schématique un procédé de détection de conditions givrantes selon un mode de réalisation de l'invention.

**EXPOSÉ DÉTAILLÉ DE MODES DE RÉALISATION PARTICULIERS**

Le concept à la base de l'invention est d'utiliser des mesures d'intensité de courant déjà disponibles, sans développement et installation de capteurs spécifiques externes et donc sans implantation de dispositifs sur la peau de l'aéronef pour détecter la présence de conditions givrantes. Par capteurs spécifiques, on entend ici des capteurs dont les mesures sont exclusivement destinées à la détection de présence de givre (par exemple un détecteur de cristaux de glace).

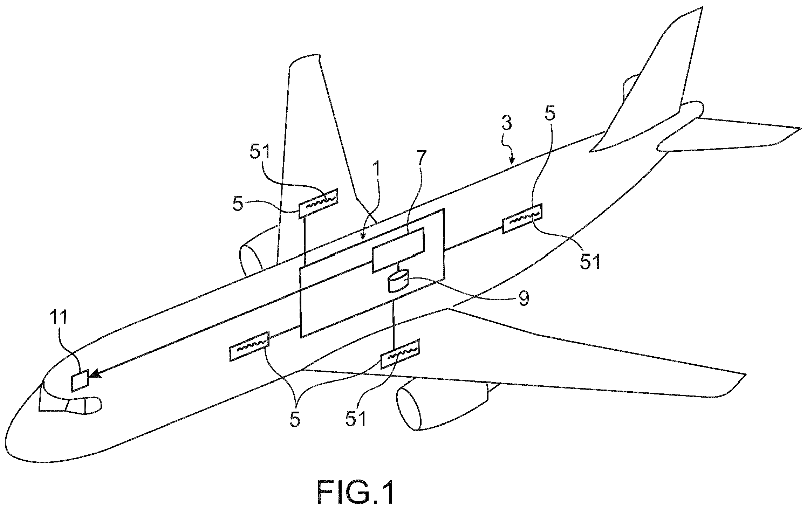

La Fig. 1 représente de manière schématique un aéronef comportant un système 1 de détection de conditions givrantes, selon un mode de réalisation de l'invention.

De manière générale, un aéronef 3 comporte différents types de sondes 5 pour surveiller les conditions de vol. En effet, des sondes de mesure de vitesse de fluide de type Pitot, des sondes de mesure d'angle d'incidence, des sondes de mesure de température, des sondes de pression, etc. sont généralement installées sur la peau de l'aéronef 3. En outre, des éléments chauffants et plus particulièrement, des circuits électriques 51 de chauffage sont intégrés à ces sondes pour les protéger des conditions givrantes. Un système de génération électrique (non illustré) de l'aéronef 3 fournit en permanence une tension électrique aux différents circuits électriques 51 de chauffages intégrés dans les différentes sondes 5. Par ailleurs, un système de surveillance de l'aéronef, comportant un calculateur 7, est configuré pour acquérir des mesures d'intensités électriques parcourant les différentes sondes 5 (plus précisément les circuits chauffants 51) afin de gérer leur consommation électrique et de vérifier le bon fonctionnement de leurs circuits électriques 51 de chauffages. L'intensité électrique parcourant une sonde 5 dépend des caractéristiques physiques de la sonde ainsi que des conditions de vol et conditions atmosphériques.

Conformément à l'invention, le calculateur 7 est en outre configuré pour comparer les intensités électriques parcourant simultanément au moins deux sondes 5 installées sur l'aéronef. A partir de cette comparaison, le calculateur 7 est configuré pour déduire les conditions de givrage.

La consommation électrique des sondes 5 dépend de la dissipation de chaleur dans l'atmosphère issue des circuits électriques 51 de chauffages. Cette dissipation de chaleur est corrélée aux conditions atmosphériques (température, pression, concentration d'eau dans les nuages, etc.) et à l'écoulement de l'air autour de la sonde. Ainsi la dissipation de la chaleur est en outre liée à l'emplacement des sondes 5 sur le fuselage. En analysant les disparités entre les intensités électriques des différentes sondes 5, le calculateur 7 est configuré pour déduire les conditions de givrage.

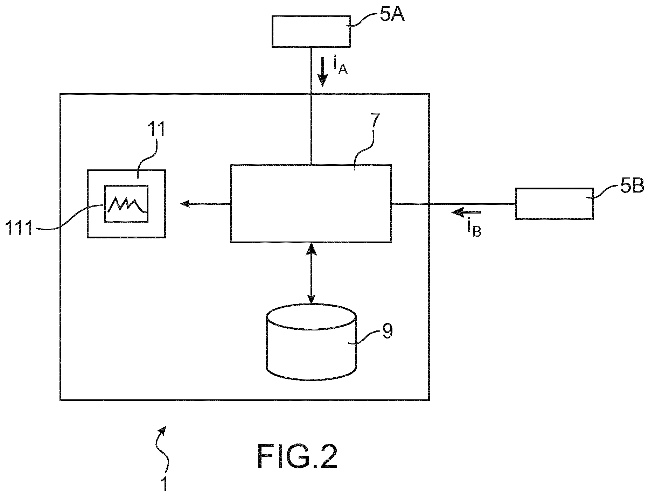

La Fig. 2 illustre de manière schématique un système de détection de conditions givrantes, selon un mode de réalisation préféré de l'invention.

Selon ce mode de réalisation, le calculateur 7 est configuré pour acquérir des première et deuxième intensités de courant $i_A$ et $i_B$ parcourant respectivement des première 5A et deuxième 5B sondes installées sur différents emplacements de l'aéronef. En outre, le calculateur 7 est configuré pour calculer le ratio de courants entre les première $i_A$ et deuxième $i_B$ intensités de courant.

Il a été constaté que dans un ciel sans nuages (i.e. hors givrage), le ratio de courants relatifs à deux sondes données est toujours égal à une constante C (appelée dans la suite constante C hors nuage) pour des conditions de vol données (altitude, température, incidence, nombre de Mach):

$$\frac{i_A}{i_B} = C$$

Ceci donne déjà une première indication dans le sens où si ce ratio n'est pas égal à la constante C hors nuage, le calculateur 7 peut directement déduire que l'aéronef se trouve dans une zone nuageuse.

Plus généralement, dans un environnement atmosphérique quelconque et en tenant compte du fait que les sondes 5 peuvent subir différents flux d'airs locaux et différentes concentrations en eau locales, le ratio des intensités de courant relatives aux première 5A et deuxième 5B sondes peut être exprimé de la manière suivante :

$$\frac{i_A}{i_B} = \frac{\beta_A}{\beta_B} \cdot k \cdot C$$

où C est la constante hors nuage pour les conditions de vol données, k un paramètre indicatif des conditions givrantes, et le ratio $\frac{\beta_A}{\beta_B}$ est le rapport entre des premier et deuxième coefficients de captation d'eau relatifs respectivement aux première 5A et deuxième 5B sondes.

Les coefficients de captation d'eau $\beta_A$ et $\beta_B$ sont prédéterminés par un code aérodynamique en fonction des conditions de vol, de l'emplacement des sondes 5A, 5B et du type de conditions atmosphériques de givrage (eau liquide ou cristaux). Le calcul de ces coefficients est déjà réalisé dans le cadre de la certification de l'aéronef et leurs valeurs sont consignées dans des abaques construits préalablement suite aux calculs aérodynamiques. Ces abaques sont enregistrés dans une unité de stockage 9 associée au calculateur 7.

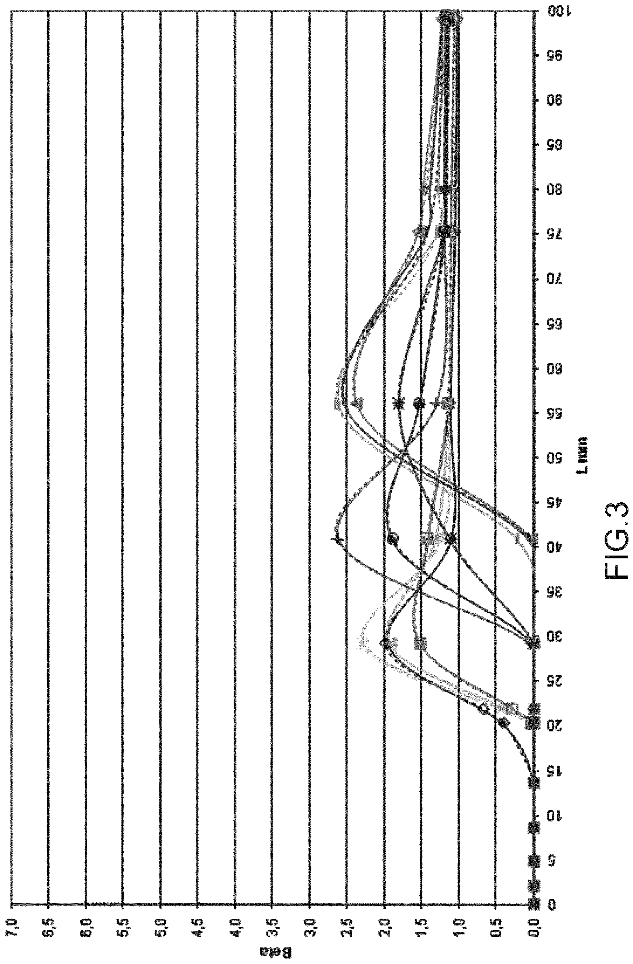

La Fig. 3 illustre à titre d'exemple des courbes de coefficients de captation d'eau en fonction de la distance de la peau de l'aéronef et selon différentes conditions de vol de l'aéronef, selon l'invention.

Les courbes illustrées sont réalisées pour des gouttelettes d'eau ayant des diamètres de quelques micromètres et chaque courbe représente une vitesse ou une condition de vol donnée de l'aéronef. On notera que l'allure générale d'une courbe de coefficient $\beta$ est croissante en s'éloignant de la peau de l'aéronef jusqu'à une certaine valeur qui dépend de la vitesse de l'aéronef et puis décroissante en tendant asymptotiquement vers la valeur « 1 ». La courbe d'un coefficient $\beta$ donne une indication précise de l'emplacement d'une sonde et surtout de sa distance par rapport à la peau de l'aéronef.

Le coefficient $\beta$ peut alors avantageusement être considéré comme un paramètre d'installation d'une sonde. Par ailleurs, étant donné que l'emplacement de chaque sonde 5 sur l'aéronef 3 est connu, le ratio $\frac{\beta_A}{\beta_B}$ relatif aux première 5A et deuxième 5B sondes est par conséquent facilement calculé par le calculateur 7 à partir des valeurs consignées dans les abaques enregistrés dans l'unité de stockage 9.

En outre, les première et deuxième intensités de courant $i_A$ et $i_B$ parcourant respectivement les première 5A et deuxième 5B sondes sont déjà acquises par le calculateur 7 et leur ratio $\frac{i_A}{i_B}$ est facilement calculé par ce dernier.

De même, la constante hors nuage C est prédéterminée par un simple calcul du ratio de courants relatif aux première 5A et deuxième 5B sondes dans des conditions atmosphériques d'air sec. Avantageusement, la valeur de la constante C hors nuage relative aux sondes correspondantes est également préenregistrée dans l'unité de stockage 9. Ainsi, le paramètre k indicatif des conditions givrantes est déterminé par le calculateur 7 en divisant le ratio de courants $\frac{i_A}{i_B}$ par le rapport $\frac{\beta_A}{\beta_B}$ entre les premier et deuxième coefficients de captation d'eau relatifs respectivement aux première 5A et deuxième 5B sondes ainsi que par la constante C hors nuage.

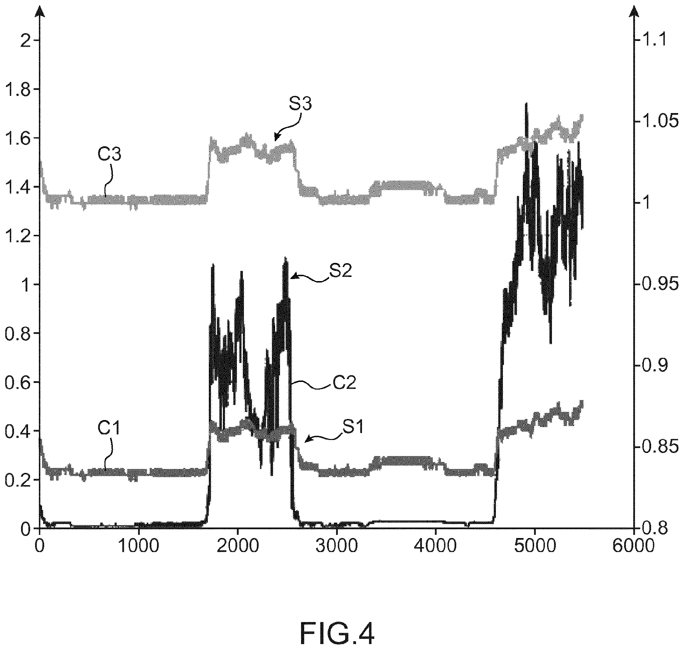

La Fig. 4 est un graphique illustrant le paramètre indicatif des conditions givrantes, selon un mode de réalisation de l'invention.

Plus particulièrement, ce graphique illustre trois paramètres en fonction du temps de vol. Le premier paramètre (courbe C1) représente le ratio $\frac{i_A}{i_B}$ de courants relatif aux intensités de courant parcourant les première 5A et deuxième 5B sondes. Le deuxième paramètre (courbe C2) représente le rapport $\frac{\beta_A}{\beta_B}$ des coefficients de captation d'eau relatif aux emplacements des première 5A et deuxième 5B sondes. Finalement, le troisième paramètre (courbe C3) représente le paramètre *k* indicatif des conditions givrantes déterminé en fonction du ratio $\frac{i_A}{i_B}$ de courants, du rapport $\frac{\beta_A}{\beta_B}$ de captation d'eau et de la constante C hors nuage. On notera que les sauts S1, S2, S3 simultanés illustrés respectivement sur les courbes C1, C2, C3 des trois paramètres indiquent la présence de conditions givrantes durant le temps de vol relatif à ces sauts S1, S2, S3. Un post-traitement supplémentaire peut être réalisé par le calculateur en comparant plus finement les valeurs du paramètre k avec les abaques enregistrés dans l'unité de stockage 9.

Avantageusement, afin d'interpréter le paramètre *k* des conditions givrantes avec plus de précision, on utilise un aéronef d'essai (non illustré) équipé du système 1 de détection selon l'invention ainsi que d'un système spécifique comprenant des capteurs de test dédiés à la détection directe et précise de concentration d'eau dans les nuages, de givre, et de la teneur en eau (cristaux et eau surfondue). En effet, lors de vols d'essai de l'aéronef d'essai, les valeurs du paramètre *k* sont déterminées par le système 1 de détection selon l'invention en même temps que l'acquisition de données précises par le système spécifique dédié à la détection directe. Ces données précises sont analysées et corrélées avec les valeurs du paramètre *k* pour former des données d'apprentissage supervisé.

Ainsi, au cours d'un vol opérationnel d'un aéronef 3, généralement du même type que celui utilisé pour les vols d'essais à ceci près qu'il ne comporte pas cette fois-ci de capteurs de test spécifiques, le calculateur 7 détermine les valeurs du paramètre *k* et les comparent aux données d'apprentissage supervisé préenregistrées dans l'unité de stockage 9 afin d'appréhender une large gamme de conditions givrantes en interprétant les valeurs du paramètre *k* avec plus de précision.

En outre, le calculateur 7 est configuré pour transmettre en temps réel les données des conditions de givrage à une interface 11 du cockpit de l'aéronef 3 (voir Figs. 1 et 2). Ainsi, ces données peuvent être affichées sur un écran 111 du cockpit et éventuellement générer une alarme. Le pilote aura alors la possibilité d'activer les systèmes de protection contre le givre. Alternativement, la condition de givrage pourra déclencher automatiquement des systèmes de protection contre le givre.

Avantageusement, le calculateur 7 est configuré pour surveiller au cours du temps l'évolution du paramètre indicatif des conditions givrantes lors des différents vols de l'aéronef 3 afin de surveiller l'évolution de la concentration en eau dans les nuages.

Par ailleurs, les données des conditions givrantes déterminées par le calculateur 7 peuvent être transmises par l'aéronef 3 à une station météorologique au sol. La station au sol peut ainsi analyser avec plus de détail ces données et se trouve avantageusement en possession de données météorologiques de plusieurs sources en altitude.

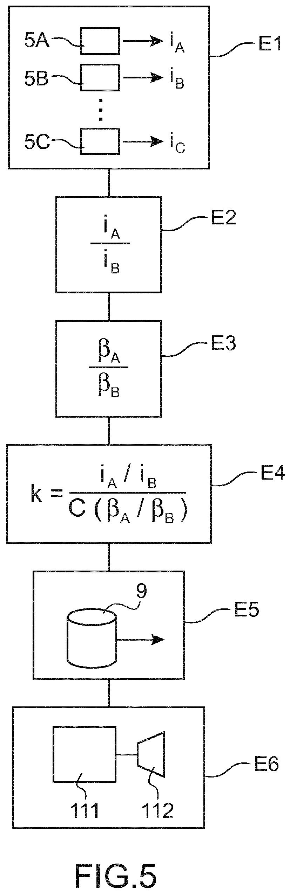

La Fig. 5 représente de manière schématique un procédé de détection de conditions givrantes selon un mode de réalisation de l'invention.

A l'étape E1, des mesures d'intensités électriques parcourant des sondes 5A-5C installées sur l'aéronef sont collectées par exemple, à intervalles réguliers du vol.

Aux étapes E2-E4, les intensités électriques $i_A$ et $i_B$ parcourant au moins deux sondes 5A, 5B installées en différents endroits de l'aéronef sont comparées et des conditions de givrage sont déduites à partir de cette comparaison. Dans le cas où les mesures d'intensités électriques sont collectées auprès d'une pluralité de sondes, ces dernières sont regroupées par couple en choisissant dans chaque couple deux sondes installées sur différents emplacements de l'aéronef. Par simplicité, on se réfère dans la suite à seulement deux intensités de courant collectées auprès de deux sondes (première 5A et deuxième 5B sondes).

Plus particulièrement, à l'étape E2, le ratio de courants $\frac{i_A}{i_B}$ entre des première et deuxième intensités $i_A$ et $i_B$ de courant parcourant respectivement les première 5A et deuxième sondes 5B est calculé.

A l'étape E3, les valeurs des coefficients de captation d'eau relatives aux première 5A et deuxième 5B sondes sont cherchées depuis les abaques préétablis. Les valeurs acquises sont celles qui correspondent aux emplacements des première et deuxième sondes ainsi qu'aux conditions courantes de vol. Ensuite, le rapport $\frac{\beta_A}{\beta_B}$ entre des premier et deuxième coefficients de captation d'eau est calculé.

A l'étape E4, le paramètre indicatif k des conditions givrantes est calculé en fonction du ratio $\frac{i_A}{i_B}$ de courants, du rapport $\frac{\beta_A}{\beta_B}$ entre les premier et deuxième coefficients de captation d'eau et de la constante C hors nuage enregistrée préalablement dans l'unité de stockage.

A l'étape E5, la détermination des conditions givrantes est éventuellement réalisée avec plus de précision en tenant compte des données d'apprentissage supervisé enregistrées au préalable.

A l'étape E6, les conditions de givrage sont affichées sur un écran 111 du cockpit et éventuellement une alarme 112 est générée lorsque du givre est détecté. Le pilote aura alors la possibilité d'activer les systèmes de protection contre le givre. Alternativement, la condition de givrage pourra déclencher automatiquement des systèmes de protection contre le givre.

## Revendications

**1.** Système de détection de conditions de givrage pour un aéronef comprenant des sondes (5) installés sur la peau de l'aéronef ainsi qu'un calculateur (7) configuré pour acquérir des mesures d'intensités électriques parcourant les sondes afin de gérer leur consommation électrique, **caractérisé en ce que** le calculateur (7) est en outre configuré pour :

calculer le ratio de courants entre des première et deuxième intensités de courant parcourant respectivement des première et deuxième sondes (5A, 5B) installées sur différents emplacements de l'aéronef, ledit ratio étant indicatif des conditions de givrage ; et
pour déterminer un paramètre indicatif des conditions givrantes en divisant ledit ratio de courants par le rapport entre des premier et deuxième coefficients de captation d'eau relatifs respectivement auxdites première et deuxième sondes (5A, 5B) ainsi que par une constante hors nuage.

**2.** Système selon la revendication 1, **caractérisé en ce que** les coefficients de captation d'eau sont prédéterminés par un code aérodynamique en fonction des conditions de vol, de l'emplacement des sondes et des conditions atmosphériques, les valeurs desdits coefficients de captation sont consignées dans des abaques qui sont stockés dans une unité de stockage (9).

**3.** Système selon la revendication 1, **caractérisé en ce que** la constante hors nuage est prédéterminée par une mesure du ratio de courants relatif auxdites première et deuxième sondes (5A, 5B) dans des conditions atmosphériques d'air sec.

**4.** Système selon l'une quelconque des revendications précédentes, **caractérisé en ce que** le calculateur est en outre configuré pour déduire les conditions de givrage en utilisant des données d'apprentissage préalablement enregistrées.

**5.** Système selon l'une quelconque des revendications précédentes, **caractérisé en ce que** les données des conditions givrantes sont indiquées en temps réel sur une interface au cockpit de l'aéronef.

**6.** Système selon l'une quelconque des revendications précédentes, **caractérisé en ce que** le calculateur (7) est configuré pour comparer deux-à-deux les intensités électriques parcourant une pluralité de sondes installées en différents endroits de l'aéronef.

**7.** Système selon l'une quelconque des revendications précédentes, **caractérisé en ce que** les données des conditions givrantes déterminées par le calculateur (7) sont transmises par l'aéronef à une station météorologique au sol.

**8.** Aéronef comportant le système de détection de conditions de givrage selon l'une quelconque des revendications précédentes.

**9.** Procédé de détection de conditions de givrage pour un aéronef, ledit aéronef comprenant des sondes installées sur sa peau, **caractérisé en ce que** ledit procédé comporte les étapes suivantes :

acquérir des mesures d'intensités électriques parcourant les sondes,
calculer le ratio de courants entre des première et deuxième intensités de courant parcourant respectivement des première et deuxième sondes (5A, 5B) installées sur différents emplacements de l'aéronef, ledit ratio étant indicatif des conditions de givrage ; et
déterminer un paramètre indicatif des conditions givrantes en divisant ledit ratio de courants par le rapport entre des premier et deuxième coefficients de captation d'eau relatifs respectivement auxdites première et deuxième sondes (5A, 5B) ainsi que par une constante hors nuage.

FIG.1

5A

$i_A$

11

7

111

5B

$i_B$

9

**FIG.2**

1

FIG.3

FIG.4

FIG.5

Europäisches
Patentamt

European
Patent Office

Office européen
des brevets

**RAPPORT DE RECHERCHE EUROPEENNE**

Numéro de la demande

EP 19 15 9019

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 3 264 103 A1 (ROSEMOUNT AEROSPACE INC [US]) 3 janvier 2018 (2018-01-03) * alinéa [0019] - alinéa [0020]; revendications 1, 4, 10 * ----- | 1-9 | INV. B64D15/20 |
| A | EP 2 870 435 A1 (SCIENCE ENGINEERING ASSOCIATES INC [US]) 13 mai 2015 (2015-05-13) * alinéa [0046] - alinéa [0052]; revendication 1 * ----- | 1-9 | |
| A | US 2013/341464 A1 (STOTHERS IAN MCGREGOR [GB] ET AL) 26 décembre 2013 (2013-12-26) * alinéa [0060] - alinéa [0064]; revendications 1, 25, 35, 37; figure 1 * ----- | 1-9 | |
| A | US 4 882 574 A (KHURGIN BORIS [US]) 21 novembre 1989 (1989-11-21) * revendication 1 * ----- | 1 | |
| A | US 2007/161878 A1 (LILIE LYLE E [US] ET AL) 12 juillet 2007 (2007-07-12) * revendications 1, 2 * ----- | 5 | DOMAINES TECHNIQUES RECHERCHES (IPC) |
| A | US 4 333 004 A (FORGUE JOHN R ET AL) 1 juin 1982 (1982-06-01) * revendication 7 * ----- | 1 | B64D G01N G01R |
| A | WO 2012/005635 A1 (SAAB AB [SE]; FIGUEROA-KARLSTROEM EDUARDO [SE]) 12 janvier 2012 (2012-01-12) * revendications 1, 7 * ----- | 8 | |

Le présent rapport a été établi pour toutes les revendications

| Lieu de la recherche | Date d'achèvement de la recherche | Examinateur |
|---|---|---|
| Munich | 5 août 2019 | Kirchmayr, Sara |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 15 9019

05-08-2019

| Document brevet cité au rapport de recherche | | Date de publication | Membre(s) de la famille de brevet(s) | | Date de publication |
|---|---|---|---|---|---|
| EP 3264103 | A1 | 03-01-2018 | BR 102017011143 | A2 | 16-01-2018 |
|  |  |  | CA 2964260 | A1 | 28-12-2017 |
|  |  |  | EP 3264103 | A1 | 03-01-2018 |
|  |  |  | US 2017370960 | A1 | 28-12-2017 |
| EP 2870435 | A1 | 13-05-2015 | EP 2870435 | A1 | 13-05-2015 |
|  |  |  | US 2014007654 | A1 | 09-01-2014 |
|  |  |  | WO 2014008339 | A1 | 09-01-2014 |
| US 2013341464 | A1 | 26-12-2013 | EP 2428447 | A2 | 14-03-2012 |
|  |  |  | EP 3228543 | A1 | 11-10-2017 |
|  |  |  | GB 2483530 | A | 14-03-2012 |
|  |  |  | GB 2543452 | A | 19-04-2017 |
|  |  |  | US 2012061482 | A1 | 15-03-2012 |
|  |  |  | US 2013341464 | A1 | 26-12-2013 |
| US 4882574 | A | 21-11-1989 | AUCUN | | |
| US 2007161878 | A1 | 12-07-2007 | EP 1976427 | A2 | 08-10-2008 |
|  |  |  | US 2007161878 | A1 | 12-07-2007 |
|  |  |  | US 2010131203 | A1 | 27-05-2010 |
|  |  |  | US 2011288776 | A1 | 24-11-2011 |
|  |  |  | WO 2008027070 | A2 | 06-03-2008 |
| US 4333004 | A | 01-06-1982 | AUCUN | | |
| WO 2012005635 | A1 | 12-01-2012 | BR 112013000307 | A2 | 31-05-2016 |
|  |  |  | EP 2591307 | A1 | 15-05-2013 |
|  |  |  | WO 2012005635 | A1 | 12-01-2012 |

EPO FORM P0460